# EUROPEAN PATENT SPECIFICATION

(11) **EP 3 868 706 B1**
(45) Date of publication and mention of the grant of the patent: **20.11.2024**
(21) Application number: 21156400.0
(22) Date of filing: 10.02.2021
(51) Int. Cl.: B81B 3/00, H02N 2/18, H02N 1/08

(54) **MEMS ELEMENT AND VIBRATION-DRIVEN ENERGY HARVESTING DEVICE**
MEMS-ELEMENT UND VIBRATIONSGETRIEBENE ENERGIEGEWINNUNGSVORRICHTUNG
ÉLÉMENT MEMS ET DISPOSITIF DE RÉCUPÉRATION D'ÉNERGIE À VIBRATIONS

(30) Priority: 21.02.2020 JP 2020028511
(43) Date of publication of application: 25.08.2021
(73) Proprietor: Saginomiya Seisakusho, Inc., Tokyo 165-0033 (JP)
(72) Inventor: ASHIZAWA, Hisayuki, Sayama-shi, Saitama 3501395 (JP); SHIMOMURA, Noriko, Sayama-shi, Saitama 3501395 (JP)
(74) Representative: V.O.

(56) References cited:
- US-A1- 2013 229 087
- US-A1- 2016 016 788
- US-B1- 6 450 031

## Description

### TECHNICAL FIELD

The present invention relates to a MEMS element and a vibration-driven energy harvesting device.

### BACKGROUND ART

There is a MEMS element known in the related art, which is manufactured by using an SOI (silicon-on-insulator) substrate and includes a fixed electrode, a movable electrode and an elastic support member for supporting the movable electrode, formed on an intermediate layer constituted with an insulating layer such as a silicon oxide layer that, in turn, is formed on a base constituted with a silicon substrate or the like. The fixed electrode includes a plurality of comb tooth electrodes, an electrode pad and a lead portion that connects the comb tooth electrodes with the electrode pad. The movable electrode includes a plurality of comb tooth electrodes that interdigitate with the comb tooth electrodes at the fixed electrode and the elastic support member includes a fixed end fixed to the base.

The fixed electrode, the movable electrode and the elastic support member are formed by adopting a MEMS machining technology. At the base, an opening, through which the comb teeth at the fixed electrode, the movable comb tooth electrodes and the area of the elastic support member excluding the fixed end are exposed, is formed. The fixed electrode is formed by forming a plurality of comb teeth, a linking portion that links the individual comb teeth with one another, the lead portion and the electrode pad all as integrated parts of the silicon oxide layer and the base, and its linking portion, lead portion and electrode pad, i.e., portions excluding the plurality of comb teeth, are fixed to the base via the intermediate layer (see, PTL 1).

### CITATION LIST

### PATENT LITERATURE

PTL 1: Japanese Laid Open Patent Publication No. 2005-323039.

US 6 450 031 B1 discloses a semiconductor physical quantity sensor comprising a substrate made of silicon having an opening, a moving comb electrode supported by the substrate for displacing over the opening, a fixed electrode comb fixed to an edge of the substrate at the opening and disposed facing the moving electrode part, and a fixed electrode pad formed on the substrate next to the opening for connecting a wire that electrically connects the fixed comb electrode.

### SUMMARY OF INVENTION

### TECHNICAL PROBLEM

In the structure disclosed in PTL 1, achieved by laminating the fixed electrode upon the base so that the entire surface of the fixed electrode to be fixed to the base faces opposite the base, the fixed electrode and the base face opposite each other over a large area. As a result, the parasitic capacitance occurring between the fixed electrode and the base is bound to be significant.

### SOLUTION TO PROBLEM

According to a 1st aspect of the present invention, a MEMS element, comprises: 2. a base constituted with a silicon substrate, a device layer electrically insulated from the base, a fixed electrode and a movable electrode formed in the device layer, the fixed electrode having a plurality of fixed comb teeth, a fixed electrode pad and a support fastening portion. The movable electrode has a plurality of movable comb teeth which are interdigitated with the fixed comb teeth. The support fastening portion includes a comb tooth linking portion that connects the plurality of fixed comb teeth and the base comprises an opening, wherein the fixed electrode and the movable electrode are at least in part disposed over the opening. The base comprises a projecting portion which projects from an edge of the opening and extends along the comb tooth linking portion, wherein a fastening portion is disposed at the end of the projecting portion, wherein the end of the comb tooth linking portion is fixed to the fastening portion at the end of the projecting portion. A portion of the base, which would face opposite at least part of the comb tooth linking portion between the fastening portion and the fixed electrode pad, is removed, forming a gap between the projecting portion and the comb tooth linking portion.

According to a 2nd aspect of the present invention, a MEMS element comprises: a base constituted with a silicon substrate, a device layer electrically insulated from the base, a fixed electrode and a movable electrode formed in the device layer, the fixed electrode having a plurality of fixed comb teeth, a fixed electrode pad and a support fastening portion. The movable electrode has a plurality of movable comb teeth which are interdigitated with the fixed comb teeth. The support fastening portion includes a comb tooth linking portion that connects the plurality of fixed comb teeth, a lead portion that connects with the fixed electrode pad, a linking portion at which the comb tooth linking portion and the lead portion are linked. The base includes a fastening portion that fastens the linking portion or an end portion of the lead portion located toward the comb electrode, and a portion of the base, which would face opposite at least part of the lead portion at the fixed electrode, is removed.

According to embodiments of the invention, it is preferable that portions of the base, which would face opposite the entire fixed comb teeth and face opposite the entire movable comb teeth, are removed.

According to embodiments of the invention the MEMS element may further comprise:
an elastic support member that supports the movable electrode, wherein: a portion of the base, excluding a fixed end at which the elastic support member is fixed to the base and a connecting portion at which the elastic support member is connected to the movable electrode, is removed.

According to a further aspect of the invention, a vibration-driven energy harvesting device comprises a MEMS according to the invention wherein: an electret is formed at least at one of the movable electrode and the fixed electrode; and the vibration-driven energy harvesting device outputs electric power generated as the movable electrode vibrates.

### ADVANTAGEOUS EFFECTS OF INVENTION

According to the present invention, the parasitic capacitance between the fixed electrode and the base can be reduced.

### BRIEF DESCRIPTION OF DRAWINGS

Fig. 1 is a plan view illustrating a first embodiment of the vibration-driven energy harvesting device according to the present invention.
Fig. 2 shows the vibration-driven energy harvesting device in Fig. 1 in a sectional view taken through line II-II.
Fig. 3 is a plan view of the first embodiment of the MEMS element according to the present invention.
Fig. 4A shows the MEMS element in Fig. 3 in a sectional view taken through line IV_{A}-IV_{A}.
Fig. 4B is an enlarged view of a region IV_{B} of the MEMS element in Fig. 3.
Fig. 4C is a sectional view taken through line IVc-IVc in Fig. 4B.
Fig. 5A is a plan view illustrating fastening portions via which the base and the intermediate layer of the MEMS element in Fig. 3 are fixed to each other.
Fig. 5B is a sectional view taken through line V_{B}-V_{B} in Fig. 3 illustrating a double-side supported lead portion.
Fig. 5C is a top view of the lead portion in Fig. 5B.
Fig. 5D is a sectional view taken through line V_{D}-V_{D} in Fig. 3, showing the first stopper 15a formed so as to overhang at the opening 102a.
Fig. 6A is a plan view illustrating a fastening structure that fixes the device layer and the base of a MEMS element to each other in variation 1 of the first embodiment.
Fig. 6B is a plan view showing fastening portions via which the device layer and the base of the MEMS element in Fig. 6A are fixed to each other.
Fig. 7A is a plan view illustrating a fastening structure that fixes the device layer and the base of a MEMS element to each other, n variation 2 of the first embodiment.
Fig. 7B is a plan view showing fastening portions via which the device layer and the base of the MEMS element in Fig. 7A are fixed to each other.
Fig. 8A is a plan view illustrating a fastening structure that fixes the device layer and the base of a MEMS element to each other, in variation 3 of the first embodiment.
Fig. 8B is a plan view showing fastening portions via which the device layer and the base of the MEMS element in Fig. 8A are fixed to each other.
Fig. 9A is a plan view illustrating a fastening structure that fixes the device layer and the base of a MEMS element to each other, in variation 4 of the first embodiment.
Fig. 9B is a plan view showing fastening portions via which the device layer and the base of the MEMS element in Fig. 9A are fixed to each other.
Fig. 10 is a plan view of a second embodiment of the MEMS element.
Fig. 11 is a plan view showing the fastening portions via which the device layer and the base of the MEMS element in Fig. 10 are fixed to each other.
Fig. 12A is a plan view illustrating a fastening structure that fixes the device layer and the base of a MEMS element to each other, in variation 1 of the second embodiment.
Fig. 12B is a plan view showing fastening portions via which the device layer and the base of the MEMS element in Fig. 12A are fixed to each other.

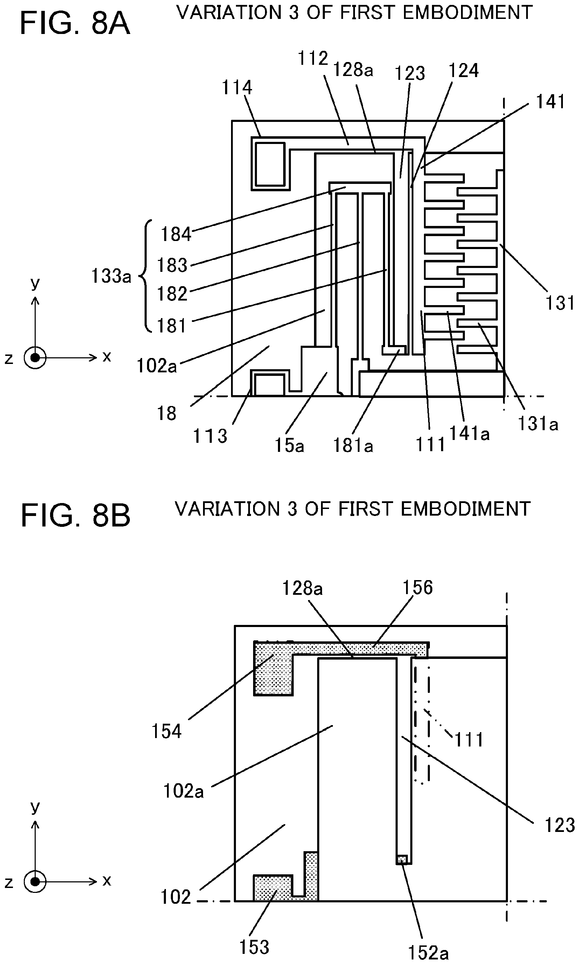

The variants shown in Figs. 8A, 8B, 10 and 11 do not form part of the claimed invention.

### DESCRIPTION OF EMBODIMENTS

A MEMS element and a vibration-driven energy harvesting device according to the present invention both relate to a structure that makes it possible to reduce a parasitic capacitance occurring in, for instance, wiring or the like, so as to extract a voltage having been generated through an external output terminal with a high level of efficiency.

### First Embodiment

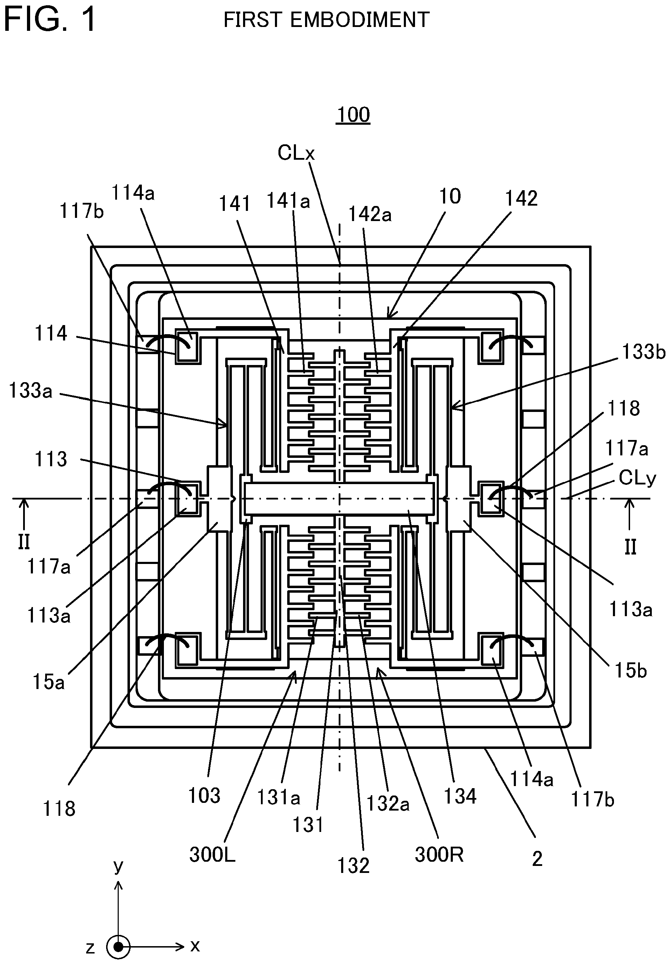

The following is a description of the first embodiment of the present invention, given in reference to Figs. 1 through 5.

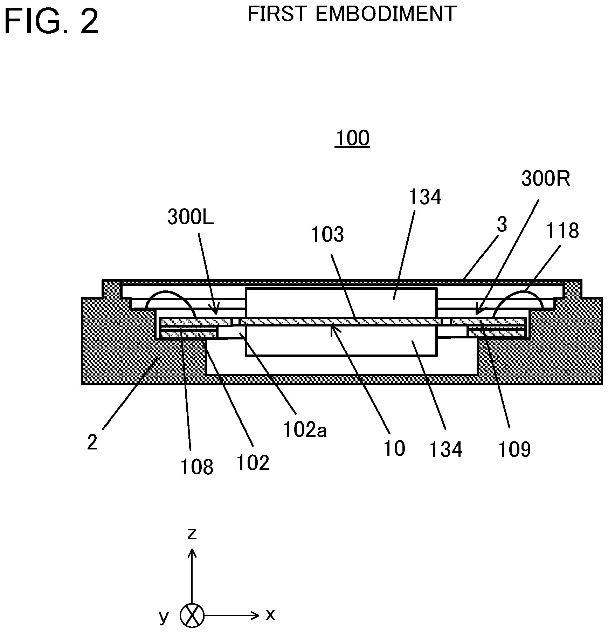

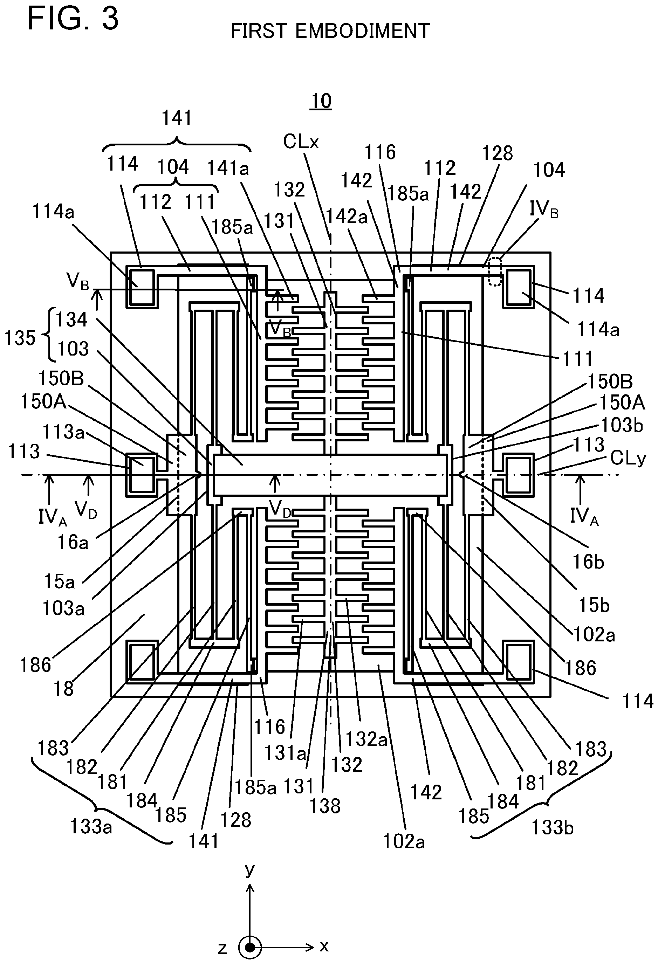

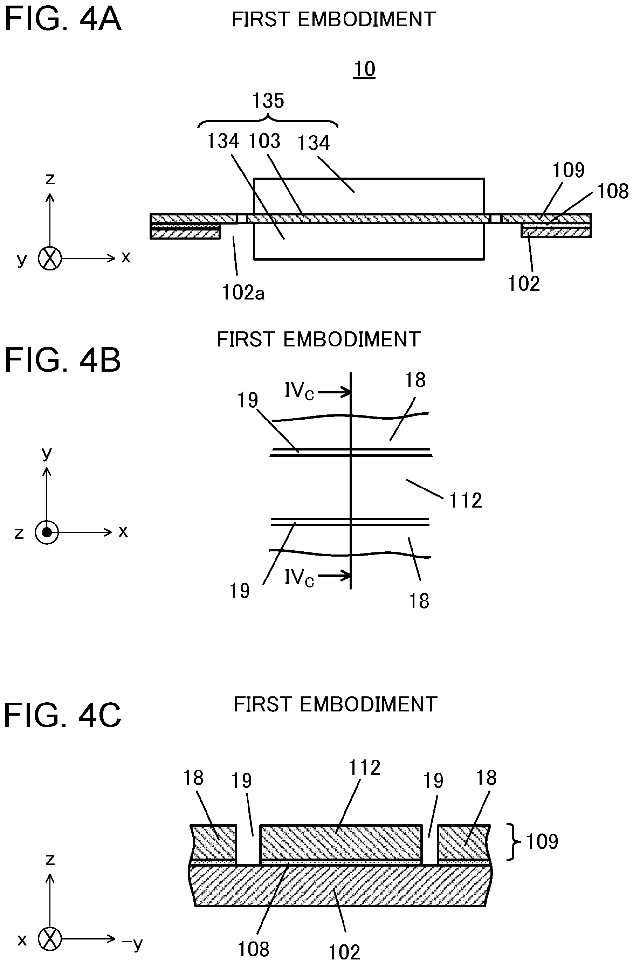

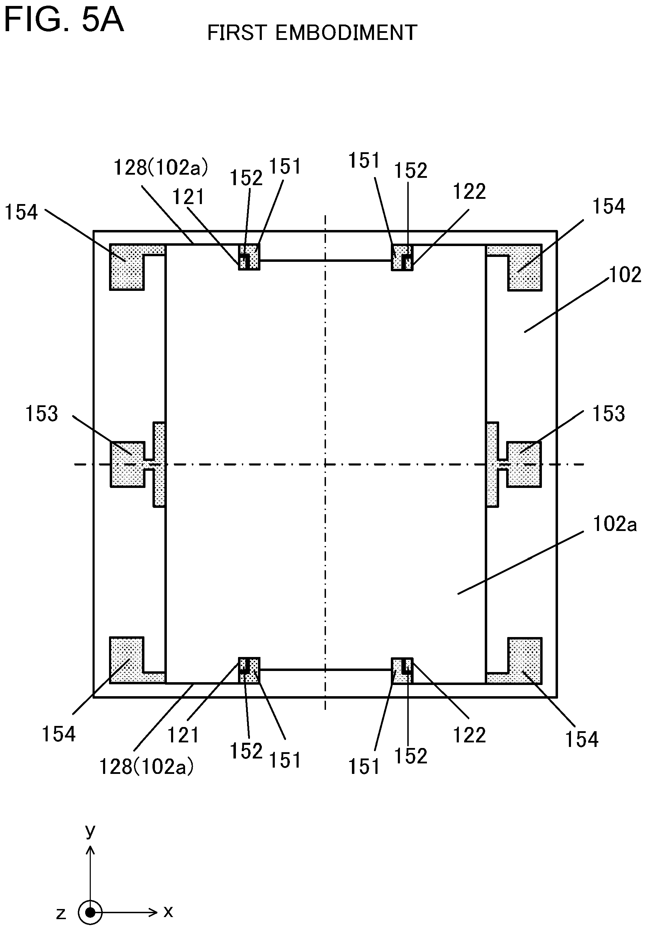

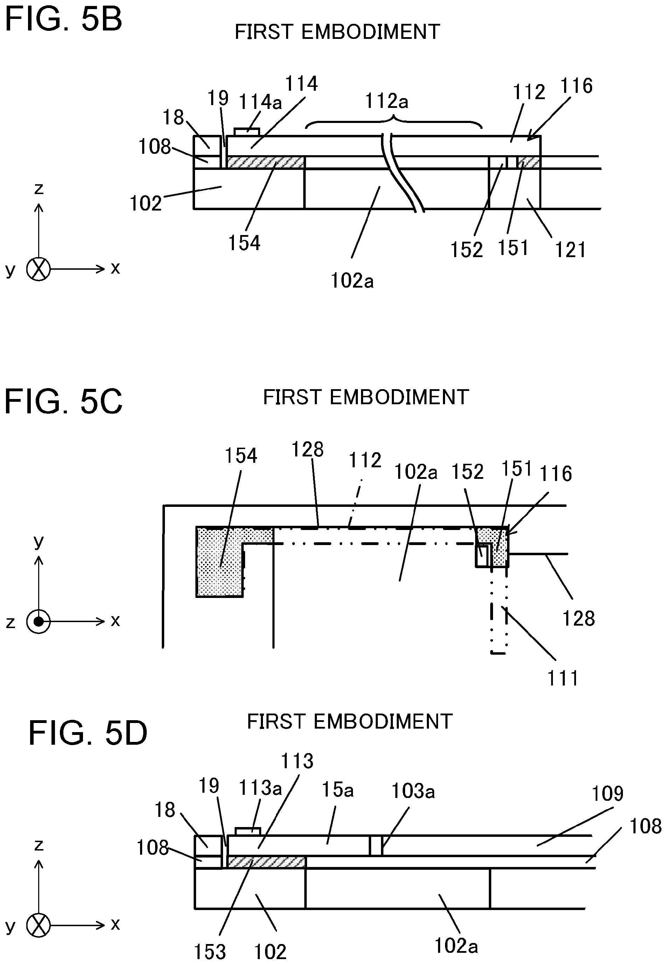

Fig. 1 is a plan view illustrating the first embodiment of the vibration-driven energy harvesting device according to the present invention, and Fig. 2 shows the vibration-driven energy harvesting device in Fig. 1 in a sectional view taken through a line II-II. Fig. 1 does not include an illustration of an upper lid disposed on the top surface side (on the positive side along a z-axis), so as to provide a clear presentation of the structure of the MEMS element in the plan view. Fig. 3 is a plan view of the first embodiment of the MEMS element according to the present invention, Fig. 4A shows the MEMS element in Fig. 3 in a sectional view taken through line IV_{A}-IV_{A}, Fig. 4B is an enlarged view of a region IV_{B} of the MEMS element in Fig. 3, and Fig. 4C is a sectional view taken through line IVc-IVc in Fig. 4B. Fig. 5A is a plan view illustrating fastening portions via which a base and an intermediate layer of the MEMS element in Fig. 3 are fixed to each other, Fig. 5B is a sectional view taken through line V_{B}-V_{B} in Fig. 3, illustrating a lead portion that is double-side supported. Fig. 5C is a top view of Fig. 5B, and Fig. 5D shows a first stopper 15a formed so as to overhang at an opening 102a in a sectional view taken through line V_{D}-V_{D} in Fig. 3.

It is to be noted that the following description will be given in reference to an x-axis, a y-axis and a z-axis running along the directions indicated in the figures. In addition, a line segment that forms a center line with respect to the x-axis (which extends along the left/right direction) is assigned with reference sign CLx and the line segment that forms a center line with respect to the y-axis (which extends along the up/down direction) is assigned with reference sign CLy in Fig. 1 and Fig. 3.

### Vibration-Driven Energy Harvesting Device 100

A vibration-driven energy harvesting device 100 in Fig. 1 is a vibration-driven energy harvesting device having mounted thereat a MEMS element 10 that adopts a comb electrode structure. As shown in Fig. 2, the vibration-driven energy harvesting device 100 comprises the MEMS element 10, a case 2 at which the MEMS element 10 is installed and an upper lid 3 that covers the top of the case 2, with the atmosphere within the case 2 sustaining a state of vacuum.

### MEMS Element 10

As shown in Fig. 4A, the MEMS element 10 comprises a base 102 constituted of Si (silicon), a device layer 109 constituted with an Si active layer, an intermediate layer 108 disposed between the base 102 and the device layer 109, which is constituted of an inorganic insulating material such as a silicon oxide or a silicon nitride. Namely, the MEMS element 10 is configured by adopting a three-layer structure achieved by laminating the base 102, the intermediate layer 108 and the device layer 109 constituted with an Si active layer along the z-axis, as illustrated in Fig. 4A and Fig. 4C. The MEMS element 10 adopting such a structure is normally manufactured through a standard MEMS machining technology by using an SOI (silicon-on-insulator) substrate.

The MEMS element 10 includes a first comb electrode structure 300L and a second comb electrode structure 300R respectively disposed on the left side and on the right side of the center line CLx. The first comb electrode structure 300L disposed on the left side of the center line CLx includes a pair of first movable electrodes 131 and a pair of first fixed electrodes 141, whereas the second comb electrode structure 300R disposed on the right side of the center line CLx includes a pair of second movable electrodes 132 and a pair of second fixed electrodes 142. The first and second movable electrodes 131 and 132 respectively include a plurality of movable comb teeth 131a and a plurality of movable comb teeth 132a connected to a movable unit 103 which functions as a comb tooth linking portion. The first and second fixed electrodes 141 and 142 respectively include a plurality of fixed comb teeth 141a and a plurality of fixed comb teeth 142a connected to comb tooth linking portions 111. The movable comb teeth 131a and 132a are set so as to face opposite the fixed comb teeth 141a and 142a respectively and interdigitate with the respective fixed comb teeth 141a and 142a. A first electret is formed at either of or both of the first movable electrodes 131 and the first fixed electrodes 141. In addition, a second electret is formed at either of or both of the second movable electrodes 132 and the second fixed electrodes 142. The first and second movable electrodes 131 and 132 are elastically supported at the base 102 via elastic support members 133a and 133b, which will be explained later. At such a vibration-driven energy harvesting device 100, power is generated as the comb teeth are displaced relative to each other.

While the structural concept of a comb electrode structure achieved in the first embodiment includes movable electrodes 131 (132), fixed electrodes 141 (142), a movable unit 103 and an elastic support member 133a (133b), the structural concept of the comb electrode structure may further include wiring portions, such as leads 112 that electrically connect the individual electrodes to electrode pads 113 and 114 functioning as external terminals, a stopper 15a (15b) and the like, as well as the electrode pads 113 and 114.

A rectangular opening 102a is formed at the base 102 as illustrated in Fig. 2 through Fig. 5D. The first and second comb electrode structures 300L and 300R are disposed within the opening 102a in their entirety or in part. The first comb electrode structure 300L and the second comb electrode structure 300R include the first movable electrodes 131, the first fixed electrodes 141, the second movable electrodes 132 and the second fixed electrodes 142, each disposed in one of the four areas partitioned by the center line CLy and the center line CLx within the opening 102a.

It is to be noted that this structural arrangement may be alternatively described as "the pair of first movable electrodes 131, the pair of first fixed electrodes 141, the pair of second movable electrodes 132 and the pair of second fixed electrodes 142 are each split so that one of the two electrodes is disposed above and the other electrode is disposed below relative to the center line CLy in the figure.

### Device Layer

The first and the second comb electrode structures 300L and 300R are formed in the device layer 109. Namely, the movable unit 103 extending along the center line CLy, the first movable electrodes 131 and the first fixed electrodes 141 disposed to the left relative to the center line CLx, the second movable electrodes 132 and the second fixed electrodes 142 disposed to the right relative to the center line CLx, a pair of elastic support members 133a and 133b that elastically support the movable unit 103 at the base 102, the first stopper 15a disposed to the left relative to the center line CLx and the second stopper 15b disposed to the right relative to the center line CLx are formed in the device layer 109.

### Movable Unit

As shown in Fig. 4A, weights 134 are fixed to the movable unit 103 with glue or the like, and the movable unit 103 and the weights 134 configure a movable assembly 135. The weights 134 are fixed to the movable unit 103 in order to generate power with high efficiency even when the environmental vibration is slight by increasing the mass of the movable unit 103.

### First and Second Movable Electrodes

The first movable electrodes 131 each include a plurality of movable comb teeth 131a, each extending toward the - side of the x-axis, which are disposed one after another over predetermined intervals along the y-axis on one side of a comb tooth linking portion 138, whereas the second movable electrodes 132 each include a plurality of movable comb teeth 132a, each extending toward the + side of the x-axis, which are disposed one after another over predetermined intervals along the y-axis. The length of the movable comb teeth 131a of the first movable electrodes 131, measured along the x-axis, and the length of the movable comb teeth 132a of the second movable electrodes 132, measured along the x-axis, are substantially equal.

The movable comb teeth 131a and 132a of the first movable electrodes 131 and the second movable electrodes 132 are connected to the common comb tooth linking portion 138, and the comb tooth linking portion 138, in turn, is connected to the movable unit 103. A left-end portion 103a of the movable unit 103 is supported at the base 102 via a pair of elastic support members 133a, one disposed above and the other disposed below the center line CLy. A right-end portion 103b of the movable unit 103 is supported at the base 102 via a pair of elastic support members 133b, one disposed above and the other disposed below the center line CLy. In the MEMS device 10 in the vibration-driven energy harvester 100 shown in Fig. 1, the elastic support members 133a are disposed in the upper and lower areas on the left side and the elastic support members 133b are disposed in the upper and lower areas on the right side.

### First and Second Fixed Electrodes

The first fixed electrodes 141 each include a plurality of fixed comb teeth 141a with which the plurality of movable comb teeth 131a of the first movable electrode 131 are interdigitated. The plurality of fixed comb teeth 141a are disposed one after another over equal intervals along the y-axis and each extend toward the + side of the x-axis. The first fixed electrodes 141 each include a comb tooth linking portion 111 via which the plurality of fixed comb teeth 141a are linked with one another, a fixed electrode pad 114 and a lead portion 112 that connects the comb tooth linking portion 111 to the fixed electrode pad 114. The plurality of fixed comb teeth 141a, the comb tooth linking portion 111, the lead portion 112 and the fixed electrode pad 114 of the first fixed electrode 141 are formed as an integrated unit in the device layer 109, by adopting a MEMS machining technology.

Likewise, the second fixed electrodes 142 each include a plurality of fixed comb teeth 142a with which the plurality of movable comb teeth 132a of the second movable electrode 132 are interdigitated. The plurality of fixed comb teeth 142a are disposed one after another over equal intervals along the y-axis and each extend toward the - side of the x-axis. The second fixed electrodes 142 each include a comb tooth linking portion 111 via which the plurality of fixed comb teeth 142a are linked with one another, a fixed electrode pad 114 and a lead portion 112 that connects the comb tooth linking portion 111 to the fixed electrode pad 114. The plurality of fixed comb teeth 142a, the comb tooth linking portion 111, the lead portion 112 and the fixed electrode pad 114 of the second fixed electrode 142 are formed as an integrated unit in the device layer 109, by adopting a MEMS machining technology.

It is to be noted that at each of the first fixed electrodes 141 and the second fixed electrodes 142, a support fastening portion 104 is configured with the comb tooth linking portion 111 and the lead portion 112. A middle part 112a of the lead portion 112 is not fixed to the base 102. In other words, the base 102 is not present underneath the middle part 112a. As a result, the parasitic capacitance in the middle part 112a is reduced.

In addition, the comb tooth linking portion 111 and the fixed comb teeth 141a may be referred to, in a narrow sense, as a fixed electrode 141.

### Elastic Support Members

The elastic support members 133a and the elastic support members 133b, which elastically support the movable unit 103, adopt structures identical to one another. The elastic support members 133a and 133b each include three support beams 181 through 183, a support beam linking portion 184 that links the support beams 181 through 183, a fastening beam 185 and a linking portion 186 that links the support beam 181 to the fastening beam 185.

The fastening structure adopted for the elastic support members 133a will be explained below.

The support beam 183, disposed at a position furthest away from the fixed electrode 141 is connected to the first stopper 15a. The corresponding support beam 181, disposed at a position closest to the same fixed electrode 141, is connected to the fastening beam 185 via the linking portion 186. The support beam 182, disposed between the support beam 181 and the support beam 183 is connected at its one end to the linking portion 184 and is connected at its other end to the end 103a of the movable unit 103. A fixed end 185a, which is an end of the fastening beam 185, is fixed to a second fastening portion 152 (see Fig. 5A) disposed in the intermediate layer 108.

The fastening structure adopted for the elastic support members 133b will be explained next.

The support beam 183, disposed at a position furthest away from the fixed electrode 142 is connected to the second stopper 15b. The support beam 181, disposed at a position closest to the same fixed electrode 142, is connected to the fastening beam 185 via the linking portion 186. The support beam 182, disposed between the support beam 181 and the support beam 183, is connected at its one end to the linking portion 184 and is connected at its other end to the end 103b of the movable unit 103. A fixed end 185a, which is an end of the fastening beam 185, is fixed to a second fastening portion 152 (see Fig. 5A) disposed in the intermediate layer 108.

### First and Second Stoppers

The first stopper 15a and the second stopper 15b have a function of regulating the amplitude with which the movable unit 103 vibrates. The first stopper 15a includes a projection 16a formed so as to face opposite one end 103a of the movable unit 103 in the x-axis. A movable electrode pad 113 is electrically connected to the first stopper 15a. The second stopper 15b includes a projection 16b formed so as to face opposite the other end 103b of the movable unit 103 in the x-axis. A movable electrode pad 113 is connected to the second stopper 15b.

If an abnormal condition or the like at the vibration source causes the movable unit 103 to move toward the - side of the x-axis by an extent greater than a predetermined degree, the one end 103a of the movable unit 103 will come into contact with the projection 16a of the first stopper 15a. If, on the other hand, the movable unit 103 moves toward the + side of the x-axis by an extent greater than a predetermined degree, the other end 103b of the movable unit 103 will come into contact with the projection 16b of the second stopper 15b. In this manner, the amplitude of the vibration of the movable unit 103 is regulated via the first stopper 15a and the second stopper 15b.

The first and second movable electrodes 131 and 132, the movable unit 103, the elastic support members 133a and 133b, the first and second stoppers 15a and 15b and the movable electrode pads 113 are formed as an integrated unit in the device layer 109 through a MEMS machining technology.

As described above, the plurality of fixed comb teeth 141a, the comb tooth linking portion 111, the lead portion 112 and the fixed electrode pad 114 of each fixed electrode 141 are formed with the device layer 109 as an integrated unit by adopting a MEMS machining technology. In addition, the plurality of fixed comb teeth 142a, the comb tooth linking portion 111, the lead portion 112 and the fixed electrode pad 114 of each second fixed electrode 142 are formed with the device layer 109 as an integrated unit by adopting a MEMS machining technology. In other words, the first comb electrode structure 300L and the second comb electrode structure 300R are each formed with the device layer 109 as an integrated unit through a MEMS machining technology.

The MEMS element 10 achieved in the first embodiment includes a wiring structure via which the first and second movable electrodes 131 and 132 are electrically connected to the movable electrode pads 113 and a wiring structure via which the comb tooth linking portions 111 at the first and second fixed electrodes 141 and 142 are electrically connected to the fixed electrode pads 114. These wiring structures are held fast and supported while, at the same time, they are insulated from the base 102. The wiring structures include the first and second stoppers 15a and 15b, the lead portions 112, the fixed electrode pads 114, the movable electrode pads 113 and the elastic support members 133a and 133b. The following is a description of the wiring structures.

A first characteristic feature of the MEMS element 10 in the first embodiment is a reduction in the parasitic capacitance in the wiring on the fixed electrode-side. Namely, the lead portions 112 that connect the comb tooth linking portions 111 at the fixed electrodes 141 and 142 with the corresponding fixed electrode pads 114 are each double-side supported, i.e., supported on two ends, by fastening support portions 151 and 154 shown in Fig. 5A, and the base 102 is partially removed so that it is not present under the middle part 112a of the lead portion 112 supported on two ends by the fastening support portions 151 and 154. The lead portion 112 and the fastening support portions 151 and 154 will be described in detail later in reference to Fig. 5A, Fig. 5B and Fig. 5C.

A second characteristic feature of the MEMS element 10 achieved in the first embodiment is that the base 102 is partially removed so that it is not present under the comb tooth linking portions 111 at the first and second fixed electrodes 141 and 142 and under the plurality of comb teeth 141a and 142a.

### Peripheral Fastening Portion

Fig. 4B shows a region IV_{B} of the MEMS element in Fig. 3 in an enlarged view, and Fig. 4C is a sectional view of Fig. 4B taken through line IV_{C} - IV_{C}.

Reference sign 18 in Fig. 3 indicates a peripheral fastening portion. The peripheral fastening portion 18 is formed so as to surround the lead portions 112 of the first and second fixed electrodes 141 and 142, to surround the fixed electrode pads 114, to surround the first and second stoppers 15a and 15b and to surround the movable electrode pads 113. As shown in Fig. 4C, the peripheral fastening portion 18 is formed in the device layer 109.

As Fig. 4B and Fig. 4C illustrate, a slit 19 is formed between the lead portion 112 and the peripheral fastening portion 18. The lead portion 112 and the peripheral fastening portion 18 are physically separated from each other and electrically insulated from each other by the slit 19.

Likewise, as Fig. 5D illustrates, the first and second stoppers 15a and 15b, together with corresponding electrode pads 113, are each physically separated and electrically insulated from the peripheral fastening portion 18 by a slit 19.

As explained earlier, the movable unit 103, the first and second movable electrodes 131 and 132 and the first and second elastic support members 133a and 133b are disposed within the opening 102a of the base 102. The fixed ends 185a of the elastic support members 133a and 133b are each supported at the second fastening portion 152 disposed at the intermediate layer 108 over the base 102 (see Fig. 5A, Fig. 5B, Fig. 5C).

### Fastening Structure for First and Second Stoppers

The first stopper 15a is disposed so that its region 150A shown in Fig. 3 is fixed to the base 102 and so that its region 150B located on the side where the projection 16a is formed hangs over the opening 102a of the base 102. In other words, the first stopper 15a is fixed to the base 102 over the region 150A ranging over half the length of the first stopper 15a measured along the x-axis.

Likewise, the second stopper 15b is disposed so that its region 150A shown in Fig. 3 is fixed to the base 102 and so that its region 150B located on the side where the projection 16b is formed hangs over the opening 102a of the base 102. In other words, the second stopper 15b is fixed to the base 102 over the region 150A ranging over half its length measured along the x-axis.

The portions of the base 102 that would be present under the regions 150B of the first and second stoppers 15a and 15b are removed.

### Lead Portions

The comb tooth linking portion 111 and the lead portion 112 at each first fixed electrode 141 extend along directions substantially perpendicular to each other, and the comb tooth linking portion 111 and the lead portion 112 are linked with each other via a linking portion 116. The linking portion 116 at the first fixed electrode 141 is fixed to the base 102 via the first fastening portion 151 formed in the intermediate layer 108 (see Fig. 5A, Fig. 5B and Fig. 5C). The fixed electrode pad 114 connected to the lead portion 112 of the first fixed electrode 141 and the end of the lead portion 112 located on the side where the fixed electrode pad 114 is present are fixed to the base 102 via the fourth fastening portion 154 formed in the intermediate layer 108 (see Fig. 5A, Fig. 5B and Fig. 5C). The middle part 112a of the lead portion 112 at the first fixed electrode 141, which is located between the linking portion 116 and the end of the lead portion 112 located toward the fixed electrode pad 114, is disposed within the opening 102a of the base 102. The portion of the base 102, which would be present under the lead middle part 112a, is removed (see Fig. 5B and Fig. 5C).

It is to be noted that an edge 128 of the opening 102a at the base 102 assumes a position substantially the same as that of a side surface of the lead portion 112 located on the outer side along the y-axis, over the region facing opposite the lead middle part 112a, i.e., the edge 128 matches with the side surface (however, the edge 128 in the illustration presented in Fig. 3 takes a position at which it does not overlap with the side surface of the lead portion 112 located on the outer side, so as to clearly indicate a position of the edge 128).

Likewise, the plurality of fixed comb teeth 142a and the comb tooth linking portion 111 at each second fixed electrode 142 are disposed within the opening 102a of the base 102. The comb tooth linking portion 111 and the lead portion 112 at the second fixed electrode 142 extend along directions substantially perpendicular to each other, and the comb tooth linking portion 111 and the lead portion 112 are linked with each other via a linking portion 116. The linking portion 116 at the second fixed electrode 142 is fixed to the base 102 via the first fastening portion 151 formed in the intermediate layer 108 (see Fig. 5A). The fixed electrode pad 114 connected to the lead portion 112 at the second fixed electrode 142 and the end of the lead portion 112 located on the side where the fixed electrode pad 114 is present are fixed to the base 102 via the fourth fastening portion 154 formed in the intermediate layer 108 (see Fig. 5A). The middle part 112a of the lead portion 112 at the second fixed electrode 142, which is located between the linking portion 116 and the end of the lead portion 112 located toward the fixed electrode pad 114, is disposed within the opening 102a of the base 102. The portion of the base 102, which would be present under the lead middle part 112a, is removed (see Fig. 5B and Fig. 5C).

It is to be noted that the edge 128 of the opening 102a at the base 102 assumes a position substantially the same as that of a side surface of the lead portion 112 located on the outer side over the region facing opposite the lead middle part 112a, i.e., the edge 128 matches with the side surface.

### Fastening Portions for the Base

Fig. 5A is a plan view showing fastening portions disposed at the base 102 and the intermediate layer 108 of the MEMS element 10 illustrated in Fig. 3.

A substantially rectangular opening 102a is formed at the base 102, and a pair of support portions 121 and a pair of support portions 122 are disposed at the opening 102a on the sides where the edges 128 are located. The support portions 121 and 122 each include the first fastening portion 151, to which the linking portion 116 belonging to the corresponding fixed electrode, among the first and second fixed electrodes 141 and 142 is fixed. In addition, the second fastening portions 152, to which the fixed ends 185a of the fastening beams 185 at the elastic support members 133a and 133b are fixed, are disposed in the intermediate layer 108 over the support portions 121 and 122.

Two third fastening portions 153, to which part of the first and second stoppers 15a and 15b and the movable electrode pads 113 are fixed, and four fourth fastening portions 154, to which the fixed electrode pads 114 and the ends of the lead portions 112 located on the side where the fixed electrode pads 114 are present are fixed, are disposed over the peripheral region of the base 102.

The fastening portions 151 through 154 are constituted with the intermediate layer 108 disposed between the device layer 109 and the base 102.

As explained earlier, the edges 128 of the opening 102a take positions that substantially match with the outer side surfaces of the lead portions 112. The edge 128 of the opening 102a project out relative to the support portions 121 and 122. In other words, the portions of the base 102 that would face opposite the lead middle parts 112a, each located between a first fastening portion 151 and a fourth fastening portion 154, are removed. As a result, the parasitic capacitance between the base 102 and the lead portions 112 can be reduced.

In addition to the portions of the base 102 that would face opposite the movable electrodes 131 and 132, the portions of the base 102 that would face opposite the comb tooth linking portions 111 and the fixed comb teeth 141a and 142a at the first and second fixed electrodes 141 and 142 are removed. This structure makes it possible to further reduce the parasitic capacitance between the base 102 and the first and second fixed electrodes 141 and 142, in comparison to a structure in which only the portions of the base 102 that would face opposite the movable electrodes 131 and 132 are removed.

As Fig. 1 and Fig. 3 indicate, pad portions 114a constituted of an electrically conductive metal such as aluminum are formed on the fixed electrode pads 114, each connected to a first fixed electrode 141 or a second fixed electrode 142. In addition, pad portions 113a constituted of an electrically conductive metal such as aluminum are formed on the movable electrode pads 113, one connected to the first stopper 15a and the other connected to the second stopper 15b. As shown in Fig. 1, the pad portions 113a and 114a are connected, each via a wire 118, respectively to electrodes 117a and 117b disposed at the case 2.

The vibration-driven energy harvester 100 is installed at a vibration source to cause the movable unit 103 to vibrate along the x-axis. The pair of elastic support members 133a and the pair of elastic support members 133b are formed so as to achieve high levels of rigidity along the y-axis and along the z-axis and the movable unit 103 is set so that it is primarily engaged in vibration along the x-axis. For instance, as the movable unit 103 is displaced toward the + side along the x-axis, the facing area (overlapping area length) over which the fixed comb teeth 142a of the second fixed electrodes 142 and the movable comb teeth 132a of the second movable electrodes 132 face opposite each other increases and the facing area over which the fixed comb teeth 141a of the first fixed electrodes 141 and the movable comb teeth 131a of the first movable electrodes 131 face opposite each other decreases. As explained earlier, the first electret is formed at either of or both of the first movable electrodes 131 and the first fixed electrodes 141, and the second electret is formed at either of or at both of the second movable electrodes 132 and the second fixed electrodes 142. As the facing areas change, electric charges induced via the electrets change. Power is generated at the MEMS element 10 as the electric charges induced between the first fixed electrodes 141 and the first movable electrodes 131 and between the second fixed electrodes 142 and the second movable electrodes 132 change and the electric power thus generated is output from the vibration-driven energy harvesting device 100.

In the first embodiment described above, the portions of the base 102 that would face opposite part of the lead portions 112 at the first and second fixed electrodes 141 and 142 (that would face opposite the middle parts 112a) are removed and also the portions of the base 102 that would face opposite part of the comb tooth linking portions 111 excluding the linking portions 116 that link with the lead portions 112, are removed. In other words, the first and second fixed electrodes 141 and 142 are fixed to the base 102 only via the fixed electrode pads 114, part of the lead portions 112 and part of the comb tooth linking portions 111.

The MEMS element 10 in the example described above assumes four comb electrode structures defined by the center lines CLx and CLy. However, the present invention may instead be adopted in a MEMS element that includes just one of the four comb electrode structures, i.e., a single comb electrode structure defined by the center lines CLx and CLy.

It is to be noted that in the embodiment described above, the portions of the base 102 that would face opposite part of the lead portions 112 at the first and second fixed electrodes 141 and 142 (that would face opposite the middle parts 112a) are removed and also the portions of the base 102 that would face opposite part of the comb tooth linking portions 111 excluding the linking portions 116, which link with the lead portions 112, are removed. In other words, the first and second fixed electrodes 141 and 142 are fixed to the base 102 only via the fixed electrode pads 114, part of the lead portions 112 and part of the comb tooth linking portions 111 in the example described above.

However, the fastening structure with which the first and second fixed electrodes 141 and 142 are fixed to the base 102 allows for a number of variations and some such variations will be described below.

### Variation 1 of First Embodiment

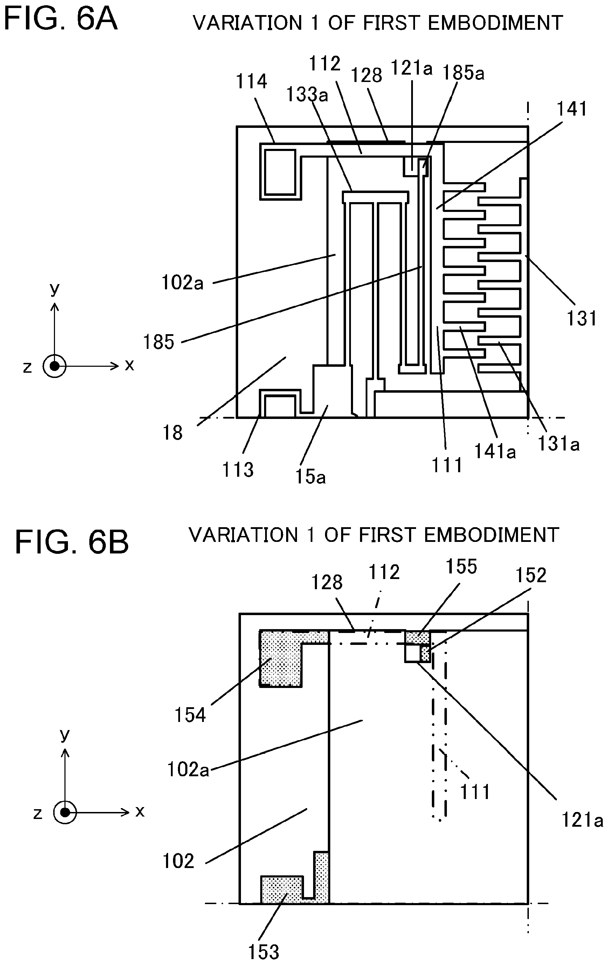

Fig. 6A shows variation 1 of the first embodiment in a plan view illustrating a fastening structure that may be adopted to fix the device layer and the base of a MEMS element to each other. Fig. 6B is a plan view showing fastening portions via which the device layer and the base of the MEMS element in Fig. 6A are fixed to each other. It is to be noted that Fig. 6A and Fig. 6B illustrate a region of the MEMS element 10 located at the upper left part of the MEMS element 10 which is one quarter of the entire MEMS element 10 in Fig. 3 and Fig. 5A, so as to simplify the drawings for better clarity.

At the MEMS element 10 achieved in the first embodiment illustrated in Fig. 3 and Fig. 5A, the first fixed electrodes 141 are each fixed to the base 102 only at a fixed electrode pad 114, the end of a lead portion 112 located toward the electrode pad and a linking portion 116 that links the comb tooth linking portion 111 to the lead portion 112. Namely, the portions of the base 102 that would be present under the middle part 112a of the lead portion 112 and under the comb tooth linking portion 111 are removed. In contrast, the first fixed electrode 141 at the MEMS element 10 in variation 1 is fixed to the base 102 only via a fixed electrode pad 114, one end of a lead portion 112 located toward the electrode pad and another end of the lead portion 112 located on the side where the comb electrode is present. In other words, the comb tooth linking portion 111 of the first fixed electrode 141 is not fixed to the base 102.

A support portion 121a in the MEMS element 10 achieved in variation 1 is disposed at a position set away (set apart) from the corresponding comb tooth linking portion 111. As Fig. 6B illustrates, the support portion 121a includes a second fastening portion 152 to which a fixed end 185a of the fastening beam 185 is fixed and a fastening portion 155 to which the other end of the lead portion 112 located toward the comb electrode is fixed. The support portion 121a in the MEMS element 10 achieved in variation 1 does not include a fastening portion via which the comb tooth linking portion 111 is fixed to the base 102. The comb tooth linking portion 111 is configured as an integrated part of the lead portion 112, and is supported indirectly at the base 102 via the lead portion 112, which is fixed at the fastening portion 155. Although not shown, the second fixed electrodes 142, too, are each fixed in a similar manner, and the comb tooth linking portions 111 of the second fixed electrodes 142 are not fixed to the base 102.

As described above, in the MEMS element 10 in variation 1, only the fixed electrode pads 114 and part of the lead portions 112 at the first and second fixed electrodes 141 and 142 are fixed to the base 102, and the comb tooth linking portions 111 are not fixed to the base 102.

Other structural features of variation 1 are similar to those illustrated in Fig. 3 and Fig. 5A, and the same reference signs are assigned to the corresponding structural features so as to preclude the necessity of a repeated explanation thereof.

### Variation 2 of First Embodiment

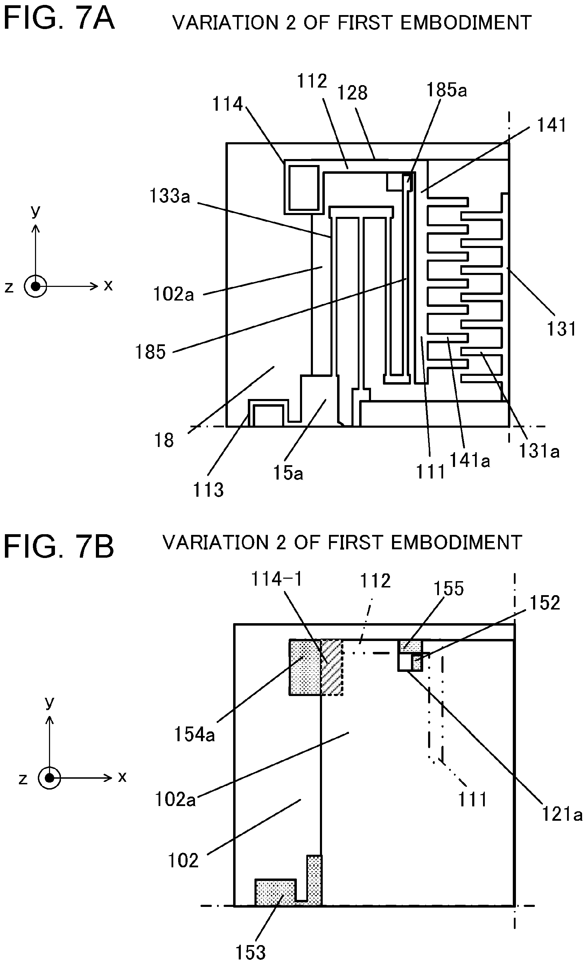

Fig. 7A shows variation 2 of the first embodiment in a plan view illustrating a fastening structure that may be adopted to fix the device layer and the base of a MEMS element to each other. Fig. 7B is a plan view showing fastening portions via which the device layer and the base of the MEMS element in Fig. 7A are fixed to each other. It is to be noted that Fig. 7A and Fig. 7B illustrate a region of the MEMS element 10 located at the upper left part of the MEMS element 10 which is one quarter of the entire MEMS element 10 in Fig. 3 and Fig. 5A, so as to simplify the drawings for better clarity.

At the MEMS element 10 achieved in the first embodiment as illustrated in Fig. 3 and Fig. 5A, the fixed electrode pads 114 of the first fixed electrodes 141 are fixed in their entirety to the base 102. In contrast, the fixed electrode pads 114 of the first fixed electrodes 141 at the MEMS element 10 achieved in variation 2 are fixed to the base 102 only in part thereof.

As Fig. 7A illustrates, a side of a fixed electrode pad 114 at a first fixed electrode 141 is set so as to take a position at the opening 102a of the base 102 and the remainder of the fixed electrode pad 114 is positioned to sit on the base 102. In other words, a region 114-1 of the fixed electrode pad 114, located on the side where the lead portion 112 is present, is formed so as to overhang at the opening 102a. As shown in Fig. 7B, a fastening portion 154a having an area corresponding to the area of the portion of the first fixed electrode 141 positioned over the base 102 is disposed on the base 102.

It is to be noted that as in variation 1, only a second fastening portion 152 and a fastening portion 155, to which the end of the lead portion 112 located toward the comb electrode is fixed, are formed at the support portion 121a, and the fastening structure does not include a fastening portion via which the comb tooth linking portion 111 is fixed to the base 102 in variation 2.

As described above, only part of the fixed electrode pad 114 and part of the lead portion 112 are fixed to the base 102, and the comb tooth linking portion 111 is not fixed to the base 102 in the MEMS element 10 in variation 2.

Other structural features of variation 2 are similar to those illustrated in Fig. 3 and Fig. 5A, and the same reference signs are assigned to the corresponding structural features so as to preclude the necessity of a repeated explanation thereof.

### Variation 3 of First Embodiment

Fig. 8A shows variation 3 of the first embodiment in a plan view illustrating a fastening structure that may be adopted to fix the device layer and the base of a MEMS element to each other. Fig. 8B is a plan view showing fastening portions via which the device layer and the base of the MEMS element in Fig. 8A are fixed to each other. It is to be noted that Fig. 8A and Fig. 8B illustrate a region of the MEMS element 10 located at the upper left part of the MEMS element 10 which is one quarter of the entire MEMS element 10 in Fig. 3 and Fig. 5A, so as to simplify the drawings for better clarity.

At the MEMS element 10 achieved in the first embodiment as illustrated in Fig. 3 and Fig. SA, the portions of the base 102 that would face opposite part of the lead portions 112 (middle parts) at the first fixed electrodes 141 are removed and also the portions of the base 102 that would face opposite the regions of the comb tooth linking portions 111 excluding the linking portions 116, which are linked with the lead portions 112 are removed. In contrast, the MEMS element 10 achieved in variation 3 adopts a structure in which the lead portion 112 of the fixed electrodes 141 are fixed in their entirety to the base 102 and the entire portion of the base 102 that would face opposite the comb tooth linking portions 111 are removed. In other words, the entire comb tooth linking portions 111 are positioned within the opening 102a.

As Fig. 8A illustrates, an edge 128a of the opening 102a of the base 102 is positioned further inward along the direction in which the y-axis extends, relative to the inner side surface of a lead portion 112 and the lead portion 112 is disposed in its entirety over the base 102. As shown in Fig. 8B, a fastening portion 156, which is connected to a fourth fastening portion 154 and extends in correspondence to substantially the entirety of the lead portion 112, is disposed at the base 102.

A projecting portion 123, which projects from the edge 128a of the opening 102a and extends along a comb tooth linking portion 111 toward the movable unit 103 is disposed at the base 102. A gap 124 between the projecting portion 123 and the comb tooth linking portion 111 separates the projecting portion 123 from the comb tooth linking portion 111 along the x-axis (see Fig. 8A).

An elastic support member 133a includes support beams 181 through 183 and a support beam linking portion 184 that links the support beams 181 through 183 at one end. However, the elastic support member 133a does not include a fastening beam 185 such as those shown in Fig. 3, and a fixed end 181a of the support beam 181, located at a front end on the side opposite from the support beam linking portion 184, is laminated on the front end of the projecting portion 123. A fastening portion 152a is disposed at the front end of the projecting portion 123 and the fixed end 181a of the support beam 181 at the elastic support member 133a is fixed to the fastening portion 152a of the projecting portion 123.

In the MEMS element 10 achieved in variation 3 as described above, the portions of the base 102 that would face opposite the entirety of comb tooth linking portions 111 at the first fixed electrodes 141 are removed, and the lead portions 112 and the regions of the first fixed electrodes 141 that face opposite the fixed electrode pads 114 are fixed in their entirety to the base 102.

Although not shown, a similar structure is adopted in conjunction with the second fixed electrodes 142, such that the portions of the base 102 that would face opposite the entirety of the comb tooth linking portions 111 of the second fixed electrodes 142 are removed and the lead portion 112 and the regions of the second fixed electrodes 142 facing opposite the fixed electrode pads 114 are fixed in their entirety to the base 102.

It is to be noted that in the structural example described above, the portions of the base 102 that would face opposite the comb tooth linking portions 111 over their entire areas at the first and second fixed electrodes 141 and 142 are removed. As an alternative, the comb tooth linking portions 111 at the first and second fixed electrodes 141 and 142 may be fixed to the base 102 only in part. In other words, the comb tooth linking portions 111 may be only partially fixed to the base 102 and significant regions of the comb tooth linking portions 111 may be positioned within the opening 102a.

In more specific terms, the MEMS element 10 in variation 3 meets a structural requirement that portions of the base that would face opposite at least part of the comb tooth linking portions 111 at the first and second fixed electrodes 141 and 142 over substantially the entirety of its width, i.e., the length running along a direction (along the x-axis) perpendicular to the direction in which the fixed comb teeth 141a and 142a are disposed one after another (along the y-axis), be removed. In other words, a structure is achieved such that portions ranging over substantially the entire width of the comb tooth linking portions 111 along the x-axis and, more desirably, over the entirety of the width of the comb tooth linking portions 111 along the x-axis, are removed.

Other structural features of variation 3 are similar to those illustrated in Fig. 3 and Fig. 5A, and the same reference signs are assigned to the corresponding structural features so as to preclude the necessity of a repeated explanation thereof.

### Variation 4 of the First Embodiment

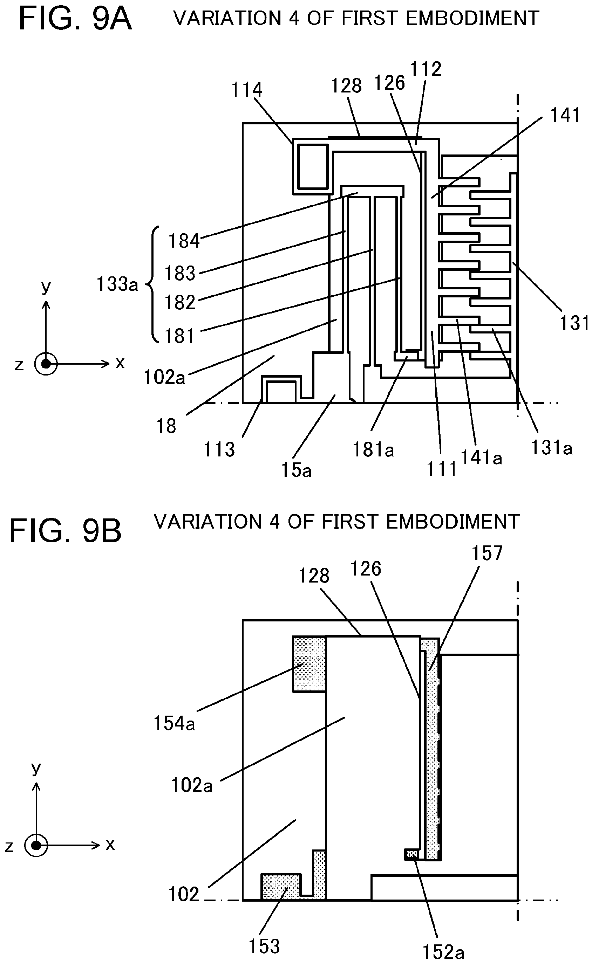

Fig. 9A shows variation 4 of the first embodiment in a plan view, illustrating a fastening structure that may be adopted to fix the device layer and the base of a MEMS element to each other. Fig. 9B is a plan view showing fastening portions via which the device layer and the base of the MEMS element in Fig. 9A are fixed to each other. It is to be noted that Fig. 9A and Fig. 9B illustrate a region of the MEMS element 10 located at the upper left part of the MEMS element 10 which is one quarter of the entire MEMS element 10 in Fig. 3 and Fig. SA, so as to simplify the drawings for better clarity.

At the MEMS element 10 achieved in the first embodiment as illustrated in Fig. 3 and Fig. 5A, the portions of the base 102 that would face opposite part of the lead portions 112 (middle parts 112a) at the first fixed electrodes 141 are removed and also the portions of the base 102 that would face opposite the regions of the comb tooth linking portions 111 excluding some part thereof (linking portions 116) are removed. In contrast, the MEMS element 10 achieved in variation 4 adopts a structure in which the comb tooth linking portions 111 of the first fixed electrodes 141 are fixed substantially in their entirety to the base 102 and portions of the base 102 that would face opposite the lead portions 112 substantially in their entirety are removed.

As Fig. 9A and Fig. 9B illustrate, an edge 128 of the opening 102a at the base 102 is set at a position that matches with a side surface of a lead portion 112, located on the outer side along the y-axis, as in the MEMS element 10 shown in Fig. 3 and Fig. 5A. At the base 102, a projecting portion 126 projecting from the edge 128 of the opening 102a and extending along a comb tooth linking portion 111 toward the movable unit 103, is formed. The projecting portion 126 is laminated under the comb tooth linking portion 111, and a fastening portion 157 to which the comb tooth linking portion 111 is fixed is disposed over the projecting portion 126.

As in variation 3, a fastening portion 152a to which a fixed end 181a present at the front end of the support beam 181 at the elastic support member 133a is fixed, is disposed at the front end of the projecting portion 126. As in variation 2, a fixed electrode pad 114 is disposed so that a side portion thereof, located on the side where the comb tooth linking portion 111 is present, overhangs the opening 102a, and the fixed electrode pad 114 is only partially fixed to the fastening portion 154a at the base 102.

As described above, at the MEMS element 10 achieved in variation 4, the portions of the base 102, which would face opposite the entire lead portions 112 of the first fixed electrodes 141 are removed and the entire comb tooth linking portions 111 are fixed to the base 102 via the fastening portions 157.

Although not shown, a similar structure is adopted for the second fixed electrodes 142, such that the portions of the base 102 that would face opposite the entire lead portions 112 of the second fixed electrodes 142 are removed and the entire comb tooth linking portions 111 are fixed to the base 102 via the fastening portions 157.

It is to be noted that the lead portions 112 and the comb tooth linking portions 111 may be only partially fixed to the base 102.

Namely, at the MEMS element 10 achieved in variation 4, the first and second fixed electrodes 141 and 142 are fixed to the base 102 only via part of the fixed electrode pads 114 and via substantially the whole of or part of the comb tooth linking portions 111.

The following operational advantages are achieved through the first embodiment and variations 1 through 4.
(1) The MEMS element 10 comprises a base 102, a first fixed electrode 141 and a second fixed electrode 142 each having a plurality of fixed comb teeth 141a or 142a, a fixed electrode pad 114 and a support fastening portion 104, and movable electrodes 131 and 132 respectively having a plurality of first movable comb teeth 131a and a plurality of second movable comb teeth 132a that are interdigitated with the fixed comb teeth 141a and the fixed comb teeth 142a respectively. The support fastening portions 104 each include a comb tooth linking portion 111 that links the plurality of fixed comb teeth 141a or 142a, and portions of the base 102 that would face opposite at least part of the comb tooth linking portions 111 over the entire length running along a direction (along the x-axis) perpendicular to a direction (y-axis) in which the fixed comb teeth 141a and 142a are set one after another, are removed. In this structure, portions of the base 102 that would face opposite at least part of the comb tooth linking portions 111 are removed. As a result, the parasitic capacitance between the base 102 and the first and second fixed electrodes 141 and 142 can be reduced. This, in turn, makes it possible to reduce the electric charges accumulated between the base 102 and the first and second fixed electrodes 141 and 142. Consequently, greater power output can be achieved in a vibration-driven energy harvesting device 100 configured with the MEMS element 10.
(2) The MEMS element 10 comprises a base 102, a first fixed electrode 141 and a second fixed electrode 142 each having a plurality of fixed comb teeth 141a or 142a, a fixed electrode pad 114 and a support fastening portion 104, and first and second movable electrodes 131 and 132 respectively having a plurality of movable comb teeth 131a and a plurality of movable comb teeth 132a that are interdigitated with the fixed comb teeth 141a and the fixed comb teeth 142a respectively. The support fastening portions 104 each include a lead portion 112 that connects the plurality of fixed comb teeth 141a or 142a to the fixed electrode pad 114, and portions of the base 102 that would face opposite at least part of the lead portions 112 of the first and second fixed electrodes 141 and 142 are removed. As a result, the parasitic capacitance between the base 102 and the lead portions 112 at the first and second fixed electrodes 141 and 142 can be reduced. This, in turn, makes it possible to reduce the electric charges accumulated between the base 102 and the first and second fixed electrodes 141 and 142. Consequently, greater power output can be achieved in a vibration-driven energy harvesting device 100 configured with the MEMS element 10.
(3) The MEMS element 10 comprises a base 102, a first fixed electrode 141 and a second fixed electrode 142 each having a plurality of fixed comb teeth 141a or 142a, a fixed electrode pad 114 and a support fastening portion 104, and first and second movable electrodes 131 and 132 respectively having a plurality of movable comb teeth 131a and a plurality of movable comb teeth 132a that are interdigitated with the fixed comb teeth 141a and the fixed comb teeth 142a respectively. The support fastening portions 104 each include a lead portion 112 that connects the plurality of fixed comb teeth 141a or 142a to the fixed electrode pad 114, and the first and second fixed electrodes 141 and 142 adopt either a structure whereby the fixed electrode pads 114 are fixed to the base 102 in their entirety or in part thereof or a structure whereby the fixed electrode pads 114 in their entirety or in part thereof, and only part of the lead portions 112, are fixed to the base 102.
   Namely, portions of the base 102 that would face opposite the regions of the lead portions 112 excluding the part described above are removed. As a result, the parasitic capacitance between the base 102 and the first and second fixed electrodes 141 and 142 can be reduced. This, in turn, makes it possible to reduce the electric charges accumulated between the base 102 and the first and second fixed electrodes 141 and 142. Consequently, greater power output can be achieved for a vibration-driven energy harvesting device 100 configured with the MEMS element 10.
(4) The MEMS element 10 comprises a base 102, a first fixed electrode 141 and a second fixed electrode 142 each having a plurality of fixed comb teeth 141a or 142a, a fixed electrode pad 114 and a support fastening portion 104, and first and second movable electrodes 131 and 132 respectively having a plurality of movable comb teeth 131a and a plurality of movable comb teeth 132a that are interdigitated with the fixed comb teeth 141a and the fixed comb teeth 142a respectively. The support fastening portions 104 each include a comb tooth linking portion 111 that links the plurality of fixed comb teeth 141a or 142a, and the first and second fixed electrodes 141 and 142 adopt either a structure whereby the fixed electrode pads 114 are fixed to the base 102 in their entirety or only in part thereof or a structure whereby the fixed electrode pads 114 in their entirety or in part and only part of the comb tooth linking portions 111 are fixed to the base 102.

Namely, at least portions of the base 102 that would face opposite the regions of the comb tooth linking portions 111 excluding the part described above are removed. As a result, the parasitic capacitance between the base 102 and the first and second fixed electrodes 141 and 142 can be reduced. This, in turn, makes it possible to reduce the electric charges accumulated between the base 102 and the first and second fixed electrodes 141 and 142. Consequently, greater power output can be achieved for a vibration-driven energy harvesting device 100 configured with the MEMS element 10.

### Second Embodiment

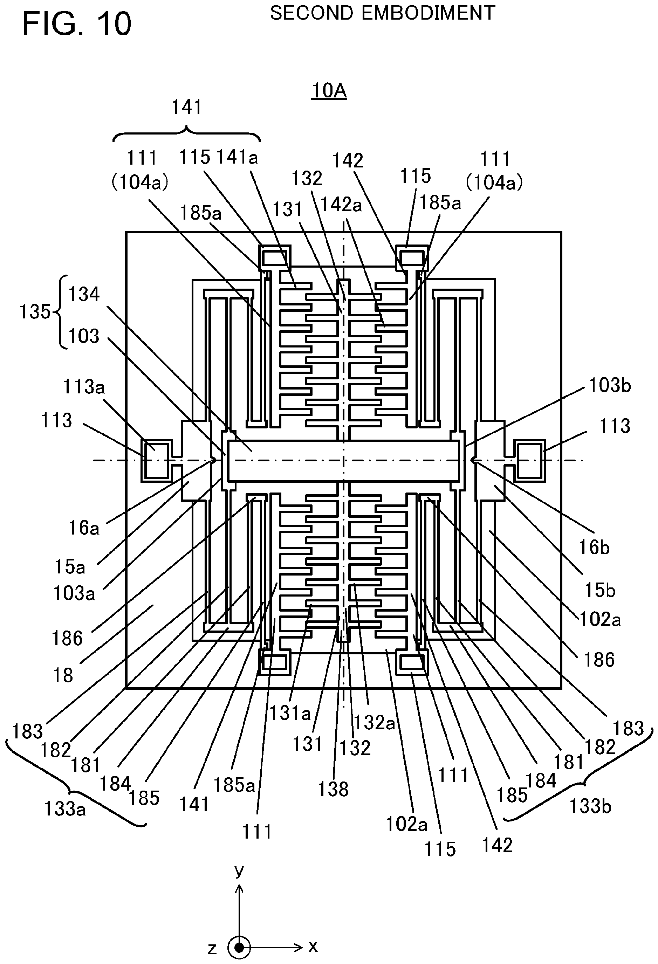

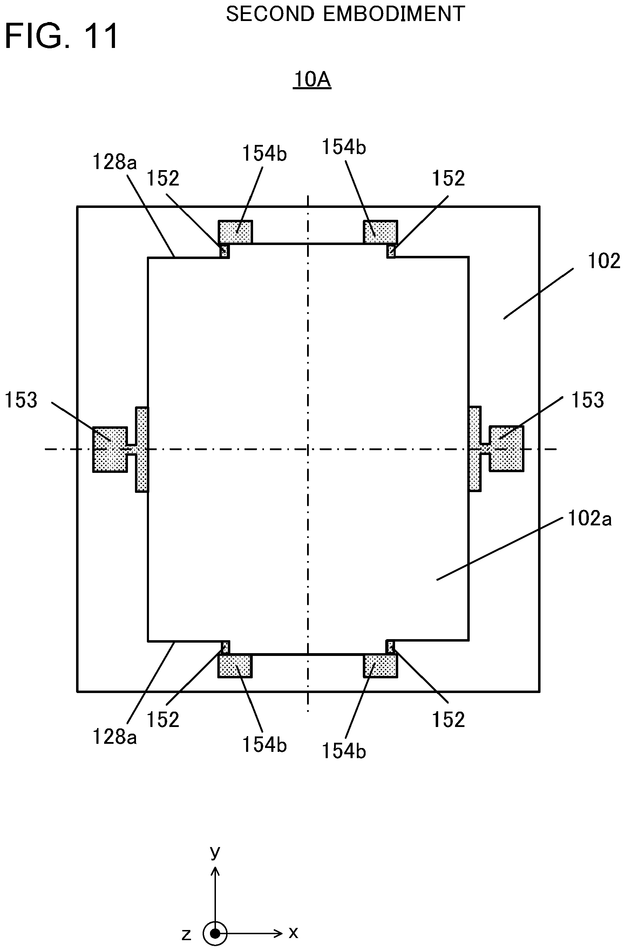

Fig. 10 shows the second embodiment of the MEMS element, and Fig. 11 is a plan view showing the fastening portions via which the device layer and the base of the MEMS element in Fig. 10 are fixed to each other.

A MEMS element 10A achieved in the second embodiment is distinguishable from the first embodiment having lead portions 112 included in the support fastening portions 104, in that support fastening portions 104a at first and second fixed electrodes 141 and 142 thereof do not include lead portions 112.

The following description will focus on structural features of the second embodiment distinguishable from those of the first embodiment.

As shown in Fig. 10, the first and second fixed electrodes 141 and 142 each include a fixed electrode pad 115. However, the first and second fixed electrodes 141 and 142 do not include lead portions 112, such as those in the first embodiment. Namely, support fastening portions 104a of the first and second fixed electrodes 141 and 142 are each constituted with a comb tooth linking portion 111 alone, which is directly linked to the corresponding fixed electrode pad 115.

The part of each fixed electrode pad 115, located on the side where it is linked with the comb tooth linking portion 111, is positioned at the opening 102a of the base 102. In other words, the fixed electrode pad 115 is fixed only in part to a fastening portion 154b disposed at the base 102, as illustrated in Fig. 11. Fixed ends 185a of the fastening beams 185 at the elastic support members 133a and 133b are fixed to second fastening portions 152 at positions matching those assumed in the first embodiment.

Other structural features of the second embodiment are similar to those described in reference to the first embodiment, and the same reference signs are assigned to the corresponding structural features so as to preclude the necessity of a repeated explanation thereof.

The first and second fixed electrodes 141 and 142 in the second embodiment do not include lead portions 112 and the comb tooth linking portions 111 in their entirety are not fixed to the base 102. In other words, the first and second fixed electrodes 141 and 142 are fixed to the base 102 via only part of the fixed electrode pads 115.

It is to be noted that in the structural example described above, the fixed electrode pads 115 are fixed to the base 102 only in part. However, the fixed electrode pads 115 may instead be fixed in their entirety to the base 102.

The MEMS element 10A in the second embodiment comprises a base 102, a first fixed electrode 141 and a second fixed electrode 142 each having a plurality of fixed comb teeth 141a or 142a, a fixed electrode pad 115 and a support fastening portion 104a, and first and second movable electrodes 131 and 132 respectively having a plurality of movable comb teeth 131a and a plurality of movable comb teeth 132a that are interdigitated with the fixed comb teeth 141a and the fixed comb teeth 142a respectively. The support fastening portions 104a each include a comb tooth linking portion 111 that links the plurality of fixed comb teeth 141a or 142a, and the first and second fixed electrodes 141 and 142 are fixed to the base 102 via the entirety of the fixed electrode pads 115 or via part of the fixed electrode pads 115. Namely, at least portions of the base 102 that would face opposite substantially the entirety of the comb tooth linking portions 111 are removed. As a result, the parasitic capacitance between the base 102 and the first and second fixed electrodes 141 and 142 can be reduced. This, in turn, makes it possible to reduce the electric charges accumulated between the base 102 and the first and second fixed electrodes 141 and 142. Consequently, greater power output can be achieved for a vibration-driven energy harvesting device 100 configured with the MEMS element 10A.

### Variation 1 of Second Embodiment

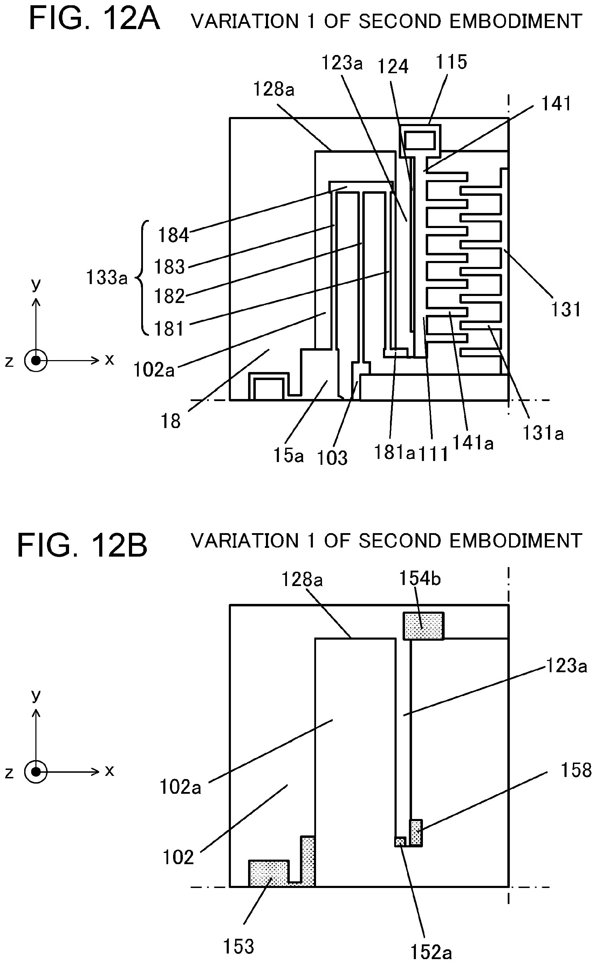

Fig. 12A shows variation 1 of the second embodiment in a plan view, illustrating a fastening structure that may be adopted to fix the device layer and the base of a MEMS element to each other. Fig. 12B is a plan view showing fastening portions via which the device layer and the base of the MEMS element in Fig. 12A are fixed to each other.

It is to be noted that Fig. 12A and Fig. 12B illustrate a region of the MEMS element 10A located at the upper left part of the MEMS element 10A which is one quarter of the entire MEMS element 10A shown in Figs. 10 and 11 so as to simplify the drawings for better clarity.

Variation 1 of the second embodiment is distinguishable from the second embodiment, in which the comb tooth linking portions 111 are not fixed in their entirety to the base 102, in that part of each comb tooth linking portion 111 is fixed to the base 102.

As Fig. 12A illustrates, a projecting portion 123a, similar to that shown in Fig. 8A, is formed so as to project from an edge 128a of the opening 102a and extend along the comb tooth linking portion 111 toward the movable unit 103. A gap 124 is present between the projecting portion 123a and the comb tooth linking portion 111.

An elastic support member 133a does not include a fastening beam 185 (see Fig. 10), and a fixed end 181a of a support beam 181 located on the side opposite from a support beam linking portion 184 is laminated on the front end of the projecting portion 123a. As illustrated in Fig. 12B, a fastening portion 152a is disposed at the front end of the projecting portion 123a, and the fixed end 181a of the support beam 181 at the elastic support member 133a is fixed to the fastening portion 152a disposed at the front end of the projecting portion 123a. In variation 1 of the second embodiment, another fastening portion 158 is disposed at the front end of the projecting portion 123a. The front end of the comb tooth linking portion 111 at each first fixed electrode 141 is fixed to the fastening portion 158.

Although not shown, a structure similar to that pertaining to the first fixed electrodes 141 is adopted for the second fixed electrodes 142, and the second fixed electrodes 142 are each fixed to the base 102 only via part of the fixed electrode pad 115 and part of the comb tooth linking portion 111.

Other structural features of the variation 1 of the second embodiment are similar to those described in reference to the second embodiment and the same reference signs are assigned to the corresponding structural features so as to preclude the necessity of a repeated explanation thereof.

The first and second fixed electrodes 141 and 142 in variation 1 of the second embodiment do not include lead portions 112 and part of the comb tooth linking portions 111 is not fixed to the base 102. Namely, the first and second fixed electrodes 141 and 142 are fixed to the base 102 only via part of the fixed electrode pads 115 and part of the comb tooth linking portions 111.

The MEMS element 10A achieved in variation 1 of the second embodiment comprises a base 102, a first fixed electrode 141 and a second fixed electrode 142 each having a plurality of fixed comb teeth 141a or 142a, a fixed electrode pad 115 and a support fastening portion 104a, and first and second movable electrodes 131 and 132 respectively having a plurality of movable comb teeth 131a and a plurality of movable comb teeth 132a that are interdigitated with the fixed comb teeth 141a and the fixed comb teeth 142a respectively. The support fastening portions 104a each include a comb tooth linking portion 111 that links the plurality of fixed comb teeth 141a or 142a, and the first and second fixed electrodes 141 and 142 adopt either a structure whereby the fixed electrode pads 115 are fixed to the base 102 in their entirety or only in part thereof or a structure whereby the fixed electrode pads 115 in their entirety or in part and only part of the comb tooth linking portions 111 are fixed to the base 102.

Namely, at least portions of the base 102 that would face opposite the regions of the comb tooth linking portions 111 excluding the part described above are removed. As a result, the parasitic capacitance between the base 102 and the first and second fixed electrodes 141 and 142 can be reduced. This, in turn, makes it possible to reduce the electric charges accumulated between the base 102 and the first and second fixed electrodes 141 and 142. Consequently, greater power output can be achieved for a vibration-driven energy harvesting device 100 configured with the MEMS element 10A.

While the MEMS elements 10 and 10A achieved in the embodiments and variations are each configured by using an SOI substrate in the description provided above, a MEMS element 10 or 10A may be formed by using a silicon substrate instead of an SOI substrate. As an alternative, the MEMS element may be formed by combining a silicon substrate, glass, metal, alumina or the like.

The MEMS elements 10 and 10A in the examples cited in reference to the embodiments each configure a vibration-driven energy harvesting device 100. However, the MEMS element according to the present invention may be a MEMS element for a vibration actuator that causes vibration of a movable electrode unit by applying a drive voltage sourced from the outside.

In addition, the present invention may be adopted in a micro-resonator adopting a structure in which a movable electrode and a fixed electrode are separated from each other via a slit, as disclosed in PTL 1 (Japanese Laid Open Patent Publication No. 2005-323039). The micro-resonator described in PTL 1 fulfills a function as a filter through which a vibration of a specific frequency in a vibration occurring between one fixed comb electrode and a movable comb electrode is extracted from another fixed comb electrode.

Moreover, the structures of the MEMS elements 10 and 10A achieved in the embodiments and variations may be adopted in various types of sensors.

While an explanation has been given on various embodiments of the present invention and variations thereof, the present invention is not limited to the particulars of these examples and any other mode conceivable within the scope of the technical teaching of the present invention is within the scope of the present invention.

### REFERENCE SIGNS LIST

- 10, 10A: MEMS element
- 100: vibration-driven energy harvesting device
- 102: base
- 102a: opening
- 103: movable unit
- 104, 104a: support fastening portion
- 108: intermediate layer
- 109: device layer
- 111: comb tooth linking portion
- 112: lead portion
- 113, 113a: movable electrode pad
- 114, 114a, 115: fixed electrode pad
- 116: linking portion
- 128, 128a: edge
- 131: first movable electrode
- 131a: movable comb tooth
- 132: second movable electrode
- 132a: movable comb tooth
- 133a, 133b: elastic support member
- 141: first fixed electrode
- 141a: fixed comb tooth
- 142: second fixed electrode
- 142a: fixed comb tooth
- 151 ~ 158: first fastening portion
- 185a: fixed end
- 300L: first comb electrode structure
- 300R: second comb electrode structure

## Claims

1. A MEMS element (10), comprising:
a base (102) constituted with a silicon substrate;
a device layer (109) electrically insulated from the base (102);
a fixed electrode (141, 142) and a movable electrode (131, 132) formed in the device layer (109);
the fixed electrode (141, 142) having a plurality of fixed comb teeth (141a, 142a), a fixed electrode pad (115) and a support fastening portion (104); and
the movable electrode (131, 132) having a plurality of movable comb teeth (131a, 132a) which are interdigitated with the fixed comb teeth (141a, 142a), wherein:
the support fastening portion (104) includes a comb tooth linking portion (111) that connects the plurality of fixed comb teeth (141a, 142a); and
the base comprises an opening (102a), wherein the fixed electrode (141, 142) and the movable electrode are at least in part disposed over the opening (102a);
**characterised in that** the base (102) comprises a projecting portion (123a) which projects from an edge (128a) of the opening (102a) and extends along the comb tooth linking portion (111), wherein a fastening portion (158) is disposed at the end of the projecting portion (123a);
wherein the end of the comb tooth linking portion (111) is fixed to the fastening portion (158) at the end of the projecting portion (123a) and a portion of the base (102), which would face opposite at least part of the comb tooth linking portion (111) between the fastening portion (158) and the fixed electrode pad (115), is removed, forming a gap (124) between the projecting portion (158) and the comb tooth linking portion (111).

2. A MEMS element (10), comprising:
a base (102) constituted with a silicon substrate;
a device layer (109) electrically insulated from the base (102);
a fixed electrode (141, 142) and a movable electrode (131, 132) formed in the device layer (109);
the fixed electrode (141, 142) having a plurality of fixed comb teeth (141a, 142a), a fixed electrode pad (114) and a support fastening portion (104); and
the movable electrode (131, 132) having a plurality of movable comb teeth (131, 132a) which are interdigitated with the fixed comb teeth (141a, 142a), wherein:
the support fastening portion (104) includes
a comb tooth linking portion (111) that connects the plurality of fixed comb teeth (141a, 142a);
a lead portion (112) that connects with the fixed electrode pad (114);
a linking portion (116) at which the comb tooth linking portion (111) and the lead portion (102) are linked; and
wherein the base (102) includes a fastening portion (151) that fastens the linking portion (116) or an end portion of the lead portion (112) located toward the comb tooth linking portion (111);
**characterised in that** a portion of the base (102) which would face opposite at least part of the lead portion (112) at the fixed electrode (141, 142) is removed.

3. The MEMS element according to claim 1 or claim 2, wherein:
portions of the base (102) which would face opposite the entire fixed comb teeth (141a, 142a) and face opposite the entire movable comb teeth (131a, 132a) are removed.

4. The MEMS element according to any one of claims 1 through 3, further comprising:
an elastic support member (133a, 133b) that supports the movable electrode (131, 132), wherein:
a portion of the base (102), excluding a fixed end (185a) at which the elastic support member is fixed to the base and a connecting portion at which the elastic support member is connected to the movable electrode, is removed.

5. A vibration-driven energy harvesting device, comprising:
the MEMS element according to any one of claims 1 through 4, wherein:
an electret is formed at least at one of the movable electrode (131, 132) and the fixed electrode (141, 142); and
the vibration-driven energy harvesting device outputs electric power generated as the movable electrode vibrates.

## Patentansprüche

1. MEMS-Element (10), umfassend:
eine Basis (102), die aus einem Siliziumsubstrat besteht;
eine Vorrichtungsschicht (109), die von der Basis (102) elektrisch isoliert ist;
eine Fest-Elektrode (141, 142) und eine bewegliche Elektrode (131, 132), die in der Vorrichtungsschicht (109) ausgebildet sind;
wobei die Fest-Elektrode (141, 142) eine Vielzahl von festen Kammzähnen (141a, 142a), eine Fest-Elektrodenfläche (115) und einen Trägerbefestigungsabschnitt (104) aufweist; und
die bewegliche Elektrode (131, 132) eine Vielzahl von beweglichen Kammzähnen (131a, 132a) aufweist, die mit den festen Kammzähnen (141a, 142a) verzahnt sind, wobei:
wobei der Trägerbefestigungsabschnitt (104) einen Kammzahn-Verknüpfungsabschnitt (111) einschließt, der die Vielzahl von festen Kammzähnen (141a, 142a) verbindet; und
die Basis eine Öffnung (102a) umfasst, wobei die Fest-Elektrode (141, 142) und die bewegliche Elektrode zumindest teilweise über der Öffnung (102a) angeordnet sind;
**dadurch gekennzeichnet, dass** die Basis (102) einen vorstehenden Abschnitt (123a) umfasst, der von einem Rand (128a) der Öffnung (102a) vorsteht und sich entlang des Kammzahn-Verknüpfungsabschnitts (111) erstreckt,
wobei ein Befestigungsabschnitt (158) an dem Ende des vorstehenden Abschnitts (123a) angeordnet ist;
wobei das Ende des Kammzahn-Verknüpfungsabschnitts (111) an dem Befestigungsabschnitt (158) am Ende des vorstehenden Abschnitts (123a) befestigt ist und ein Abschnitt der Basis (102), der zumindest einem Teil des Kammzahn-Verknüpfungsabschnitts (111) zwischen dem Befestigungsabschnitt (158) und dem festen Elektrodenkissen (115) gegenüberliegen würde, entfernt ist, wodurch ein Spalt (124) zwischen dem vorstehenden Abschnitt (158) und dem Kammzahn-Verknüpfungsabschnitt (111) gebildet wird.

2. MEMS-Element (10), umfassend:
eine Basis (102), die aus einem Siliziumsubstrat besteht;
eine Vorrichtungsschicht (109), die von der Basis (102) elektrisch isoliert ist;
eine Fest-Elektrode (141, 142) und eine bewegliche Elektrode (131, 132), die in der Vorrichtungsschicht (109) ausgebildet sind;
wobei die Fest-Elektrode (141, 142) eine Vielzahl von festen Kammzähnen (141a, 142a), ein festes Elektrodenkissen (114) und einen Trägerbefestigungsabschnitt (104) aufweist; und
wobei die bewegliche Elektrode (131, 132) eine Vielzahl von beweglichen Kammzähnen (131, 132a) aufweist, die mit den festen Kammzähnen (141a, 142a) verzahnt sind, wobei:
der Trägerbefestigungsabschnitt (104) Folgendes einschließt:
einen Kammzahn-Verknüpfungsabschnitt (111), der die Vielzahl der festen Kammzähne (141a, 142a) miteinander verbindet;
einen Leitungsabschnitt (112), der mit dem festen Elektrodenkissen (114) eine Verbindung herstellt;
einen Verknüpfungsabschnitt (116), an dem der Kammzahn-Verknüpfungsabschnitt (111) und der Leitungsabschnitt (102) verknüpft sind; und
wobei die Basis (102) einen Befestigungsabschnitt (151) einschließt, der den Verknüpfungsabschnitt (116) oder einen Endabschnitt des Leitungsabschnitts (112), der sich in Richtung des Kammzahn-Verknüpfungsabschnitts (111) befindet, befestigt;
**dadurch gekennzeichnet, dass** ein Abschnitt der Basis (102), der zumindest einem Teil des Leitungsabschnitts (112) an der festen Elektrode (141, 142) gegenüberliegen würde, entfernt wird.

3. MEMS-Element nach Anspruch 1 oder Anspruch 2, wobei:
Abschnitte der Basis (102), die den gesamten festen Kammzähnen (141a, 142a) gegenüberliegen und den gesamten beweglichen Kammzähnen (131a, 132a) gegenüberliegen würden, entfernt werden.

4. MEMS-Element nach einem der Ansprüche 1 bis 3, ferner umfassend:
ein elastisches Trägerelement (133a, 133b), das die bewegliche Elektrode (131, 132) trägt, wobei:
ein Abschnitt der Basis (102) mit Ausnahme eines festen Endes (185a), an dem das elastische Trägerelement an der Basis befestigt ist, und eines Verbindungsabschnitts, an dem das elastische Trägerelement mit der beweglichen Elektrode verbunden ist, entfernt wird.

5. Vibrationsgetriebene Energiegewinnungsvorrichtung, umfassend:
das MEMS-Element nach einem der Ansprüche 1 bis 4, wobei:
ein Elektret an mindestens einer der beweglichen Elektrode (131, 132) und der festen Elektrode (141, 142) ausgebildet ist; und
die vibrationsgetriebene Energiegewinnungsvorrichtung elektrische Energie ausgibt, die erzeugt wird, wenn die bewegliche Elektrode vibriert.

## Revendications

1. Élément MEMS (10) comprenant :
une base (102) constituée avec un substrat en silicium ;
une couche de dispositif (109) électriquement isolée de la base (102) ;
une électrode fixe (141, 142) et une électrode mobile (131, 132) formées dans la couche de dispositif (109) ;
l'électrode fixe (141, 142) ayant une pluralité de dents de peigne fixes (141a, 142a), une électrode plane fixe (115) et une partie de fixation de support (104) ; et
l'électrode mobile (131, 132) ayant une pluralité de dents de peigne mobiles (131a, 132a) qui sont interdigitées avec les dents de peigne fixes (141a, 142a), dans lequel :
la partie de fixation de support (104) comprend une partie de liaison de dent de peigne (111) qui raccorde la pluralité de dents de peigne fixes (141a, 142a) ; et
la base comprend une ouverture (102a), dans lequel l'électrode fixe (141, 142) et l'électrode mobile sont au moins en partie disposées sur l'ouverture (102a) ;
**caractérisé en ce que** la base (102) comprend :
une partie en saillie (123a) qui fait saillie d'un bord (128a) de l'ouverture (102a) et s'étend le long de la partie de liaison de dent de peigne (111), dans lequel une partie de fixation (158) est disposée à l'extrémité de la partie en saillie (123a) ;
dans lequel l'extrémité de la dent de liaison de dent de peigne (111) est fixée sur la partie de fixation (158) au niveau de l'extrémité de la partie en saillie (123a) et une partie de la base (102), qui est orientée à l'opposé d'au moins une partie de la partie de liaison de dent de peigne (111) entre la partie de fixation (158) et l'électrode plane fixe (115) est retirée, formant un interstice (124) entre la partie en saillie (158) et la partie de liaison de dent de peigne (111).

2. Élément MEMS (10) comprenant :
une base (102) constituée avec un substrat en silicium ;
une couche de dispositif (109) électriquement isolée de la base (102) ;
une électrode fixe (141, 142) et une électrode mobile (131, 132) formées dans la couche de dispositif (109) ;
l'électrode fixe (141, 142) ayant une pluralité de dents de peigne fixes (141a, 142a), une électrode plane (114) et une partie de fixation de support (104) ; et
l'élément mobile (131, 132) ayant une pluralité de dents de peigne mobiles (131, 132a) qui sont interdigitées avec les dents de peigne fixes (141a, 142a), dans lequel :
la partie de fixation de support (104) comprend :
une partie de liaison de dent de peigne (111) qui raccorde la pluralité de dents de peigne fixes (141a, 142a) ;
une partie de conducteur (112) qui se raccorde avec l'électrode plane fixe (114) ;
une partie de liaison (116) au niveau de laquelle la partie de liaison de dent de peigne (111) et la partie de conducteur (102) sont reliées ; et
dans lequel la base (102) comprend une partie de fixation (151) qui fixe la partie de liaison (116) ou une partie d'extrémité de la partie de conducteur (112) positionnée vers la partie de liaison de dent de peigne (111) ;
**caractérisé en ce qu'**une partie de la base (102), qui est orientée à l'opposé d'au moins une partie de la partie de conducteur (112) au niveau de l'électrode fixe (141, 142), est retirée.

3. Élément MEMS selon la revendication 1 ou la revendication 2, dans lequel :
des parties de la base (102), qui sont orientées à l'opposé de toutes les dents de peigne fixes (141a, 142a) et sont orientées à l'opposé de toutes les dents de peigne mobiles (131a, 132a), sont retirées.

4. Élément MEMS selon l'une quelconque des revendications 1 à 3, comprenant en outre :
un élément de support élastique (133a, 133b) qui supporte l'électrode mobile (131, 132), dans lequel :
une partie de la base (102), excluant une extrémité fixe (185a), au niveau de laquelle l'élément de support élastique est fixé à la base et une partie de raccordement au niveau de laquelle l'élément de support élastique est raccordé à l'électrode mobile, est retirée.

5. Dispositif de récupération d'énergie à vibrations comprenant :
l'élément MEMS selon l'une quelconque des revendications 1 à 4, dans lequel :
un électret est formé au moins au niveau de l'une parmi l'électrode mobile (131, 132) et l'électrode fixe (141, 142) ; et
le dispositif de récupération d'énergie à vibrations produit de l'énergie électrique lorsque l'électrode mobile vibre.
